# EUROPÄISCHE PATENTSCHRIFT

(11) **EP 1 264 002 B1**
(45) Veröffentlichungstag und Bekanntmachung des Hinweises auf die Patenterteilung: **16.03.2005**
(21) Anmeldenummer: 01951109.6
(22) Anmeldetag: 27.01.2001
(51) Int. Cl.: C23C 16/455, C23C 16/448

(54) **GASVERSORGUNGSVORRICHTUNG FÜR PRECURSOREN GERINGEN DAMPFDRUCKS**
GAS SUPPLY DEVICE FOR PRECURSORS WITH A LOW VAPOR PRESSURE
DISPOSITIF D'ALIMENTATION EN GAZ DESTINE A DES PRECURSEURS DE FAIBLE PRESSION DE VAPEUR

(30) Priorität: 10.02.2000 DE 10005820
(43) Veröffentlichungstag der Anmeldung: 11.12.2002
(73) Patentinhaber: SCHOTT AG, 55122 Mainz (DE)
(72) Erfinder: BAUCH, Hartmut, 61276 Weilrod (DE); BEWIG, Lars, 37581 Bad Gandersheim (DE); KLIPPE, Lutz, 65187 Wiesbaden (DE); KÜPPER, Thomas, 37581 Bad Gandersheim (DE)
(74) Vertreter: Dr. Weitzel & Partner
(86) Internationale Anmeldenummer: PCT/EP2001/000888
(87) Internationale Veröffentlichungsnummer: WO 2001/059176

(56) Entgegenhaltungen:
- US-A- 5 186 120
- US-A- 5 480 488
- US-A- 5 614 247

## Beschreibung

Die Erfindung betrifft die Verwendung einer Gasversorgungsvorrichtung für Precursoren geringen Dampfdrucks, insbesondere für CVD-Beschichtungsanlagen, nach dem Oberbegriff des Anspruchs 1.

Bei modernen CVD-Beschichtungsanlagen (Chemical Vapour Deposition = chemische Gasphasenabscheidung) werden immer speziellere Beschichtungen auf Bauteilen oder Substraten aufgebracht. Dabei müssen die Beschichtungen, die auch aus einer Abfolge mehrerer verschiedener dünner Schichten bestehen können, sehr hohen Anforderungen an ihre Eigenschaften genügen. Um diese Eigenschaften zu erreichen, werden wiederum an die Qualität der Abscheidung sehr hohe Anforderungen gestellt. Hierzu zählt z.B. die Abscheiderate als Abscheideparameter, die wesentlich Einfluß auf die Schichtqualität hat. Bei CVD-Abscheideverfahren wird die Abscheiderate durch den Partialdruck eines gasförmigen Precursors entscheidend bestimmt. Daher muß der Partialdruck sehr genau eingestellt werden und darf keinen Schwankungen unterliegen.

Zur Beschichtung werden spezielle Schichtmaterialien eingesetzt, die über ausgewählte Precursoren in die Beschichtungsanlage eingebracht werden. Als Precursoren werden beispielsweise zur Herstellung von TiO₂-/SiO₂-Wechselschichten Titantetrachlorid (TiCl₄) oder Hexamethyldisiloxan (HDMSO) verwendet, die unter Normalbedingungen einen geringen Dampfdruck weit unter Atmosphärendruck aufweisen. Dieser geringe Dampfdruck ist für eine ausreichende Abscheiderate, die bei der industriellen Beschichtung benötigt wird, meist zu klein. Daher müssen die Precursoren in einem Vorratsbehälter auf eine erste Verdampfungstemperatur aufgeheizt werden, wodurch ein ausreichend hoher Dampfdruck entsteht.

Zur Verhinderung einer Kondensation des Precursors auf dem Weg zur Beschichtungsanlage muß dann die Gasversorgungsvorrichtung von dem Vorratsbehälter bis zur Beschichtungsanlage auf eine zweite Temperatur aufgeheizt werden, die über der ersten Verdampfungstemperatur liegt.

Weiterhin ist bekannt, die Precursoren bzw. schichtbildenden Materialien TiCl₄ und Hexamethyldisiloxan in einem Zwischenspeicher bei einem Dampfdruck von etwa 50 mbar oder mehr zwischenzuspeichern, damit sie durch nachfolgende Ventile, Massendurchflußregler und Rohrsysteme einen ausreichend hohen Massendurchfluß aufweisen. Um einen solchen Partialdruck zu erreichen, wird der Zwischenspeicher auf mindestens 50°C für TiCl₄ bzw. 30°C für Hexamethyldisiloxan aufgeheizt.

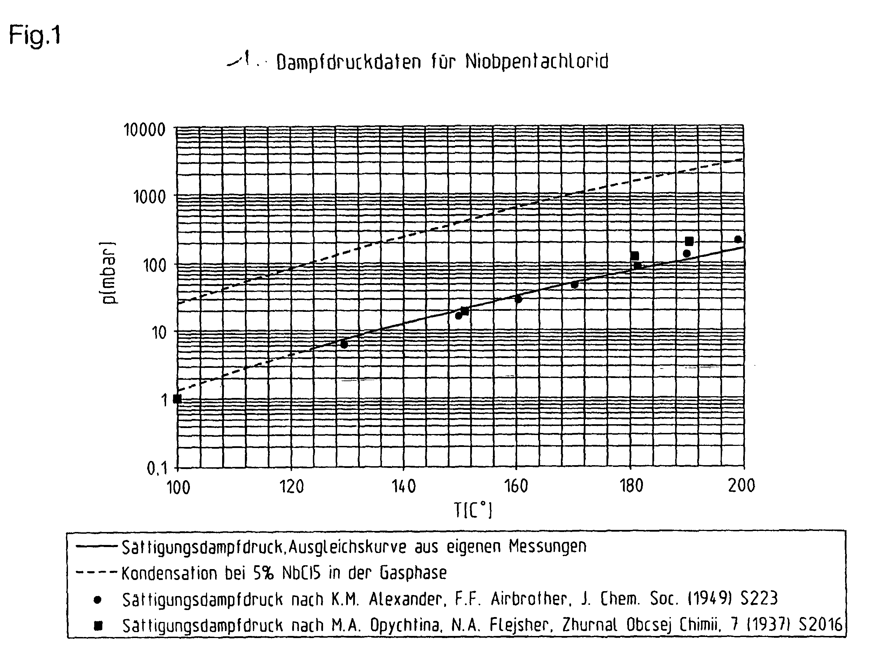

Daneben können auch Nb₂O₂-/SiO₂-Wechselschichten hergestellt werden, die den Vorteil aufweisen, daß sie weniger zur Kristallisation neigen. Außerdem ist die Abscheidung von NbO₂ mit höheren Abscheideraten möglich. Zusätzlich ist der Ausdehnungskoeffizient von Nb₂O₅ besser an den von SiO₂ angepaßt als der Ausdehnungskoeffizient von TiO₂, so daß dickere Wechselschichten mit Nb₂O₅ herstellbar sind. Zur Herstellung einer Nb₂O₅-Schicht stehen jedoch nur Precursoren mit vergleichsweise geringem Dampfdruck zur Verfügung, deren Dampfdruck unter Normalbedingungen sogar noch weit unter dem Dampfdruck der Precursoren HMDSO und TiCl₄ liegt Eine kommerziell erhältliche Nb-Verbindung mit dem höchsten Dampfdruck, NbCl₅, hat erst bei einer Temperatur von ca. 170° C einen Druck von 50 mbar. Die Temperaturabhängigkeit des Dampfdrucks von NbCl₅ ist in der unteren Kurve von Fig. 1 dargestellt. Eine Gasversorgungsvorrichtung zur gleichmäßigen Versorgung einer PICVD-Beschichtungsanlage mit NbCl₅- Dampf müßte deshalb auf dieser Temperatur gehalten werden.

Eine Gasversorgungsvorrichtung zur Bereitstellung von Precursoren mit niedrigem Dampfdruck mit einem Vorratsbehälter für einen Precursor und einem Zwischenspeicher zum Puffern und Mischen des dampfförmigen Precursors mit anderen Gasen ist bekannt (JP 2 - 25 09 77 A2). Der Vorratsbehälter wird auf eine erste Temperatur T1 und der Zwischenspeicher auf eine zweite Temperatur T2 thermostatisiert, wobei die erste Temperatur T1 niedriger als die zweite Temperatur T2 ist, damit die Kondensation des Precursors im Zwischenspeicher verhindert wird. In den Vorratsbehälter wird ein Trägergas eingeleitet, das den Precursor in den Zwischenspeicher und von dort in eine Reaktionskammer transportiert. Die Gasversorgungsvorrichtung kann mit einem zweiten Vorratsbehälter ausgestattet sein, aus dem ein zweiter Precursor mittels Trägergas in den Zwischenspeicher eingeleitet wird, so daß sich die beiden Precursoren und das Trägergas mischen. Bei dieser Vorrichtung muß der Zwischenspeicher und die damit verbundenen Einrichtungen auf der hohen Temperatur T2 gehalten werden, wodurch Wartungsarbeiten durch die notwendige Abkühlzeit zeitaufwendig sind und die verwendeten Materialien und Einrichtungen der hohen Temperatur T2 stand halten müssen.

Gattungsgemäß ist eine Gasversorgungsvorrichtung für Precursoren geringen Dampfdrucks, insbesondere für eine PICVD-Beschichtungsanlage, bei der ein Vorratsbehälter für den Precursor auf einer ersten Temperatur gehalten wird, bekannt (DE 42 36 324 C 1). Weiterhin weist diese Gasversorgungsvorrichtung einen Zwischenspeicher zum Zwischenspeichern des dampfförmigen Precursors auf, wobei der Zwischenspeicher über eine Gasleitung mit dem Vorratsbehälter verbunden ist Aus dem Zwischenspeicher kann das Gas mit dem Precursor für die PICVD-Beschichtungsanlage entnommen werden. Bei dieser Gasversorgungsvorrichtung wird der Zwischenspeicher auf einer zweiten Temperatur gehalten, die höher als die erste Temperatur des Vorratsbehälters ist Durch den Zwischenspeicher werden Druckschwankungen des Gases mit dem Precursor durch Entnahmen mit unterschiedlichem Massendurchfluß in die PICVD-Beschichtungsanlage weitgehend ausgeglichen.

Für Reparaturen oder regelmäßig durchzuführende Wartungsarbeiten am Zwischenspeicher muß jedoch der Zwischenspeicher und die damit verbundenen Einrichtungen zum Zuführen und Entnehmen des Gases unter hohem Zeitaufwand abgekühlt werden. Auch erfordert dies den Einsatz teurer Hochtemperatur-Massendurchflußregler im Bereich des Zwischenspeichers. Darüber hinaus wird bei einer Dauerentnahme der maximal zu entnehmende Precursor-Massenstrom durch die Verdampfungsrate des auf geringerer Temperatur gehaltenen Vorratsbehälters begrenzt.

US-A-5480488, US-A-5614247 und US-A-5186120 zeigen ebenfalls Gasversorgungsvorrichtungen, bei denen die Temperatur in einem Zwischenspeicher hinter einem Vorratsbehälter oberhalb der Temperatur des Vorratsbehälters gehalten wird

Aufgabe der Erfindung ist es, eine Gasversorgungsvorrichtung für einen Precursor geringen Dampfdrucks so zu verwenden, daß an einem Zwischenspeicher Wartungs- und Reparaturarbeiten einfach und schnell durchgeführt werden können und für den Zwischenspeicher und dessen Bauelemente günstige Komponenten zum Einsatz kommen, ohne den maximal erreichbaren Massendurchsatz des Precursors einschränken zu müssen.

Diese Aufgabe wird mit den Merkmalen des Anspruchs 1 gelöst.

Gemäß Anspruch 1 weist eine Gasversorgungsvorrichtung für Precursoren geringen Dampfdrucks einen Vorratsbehälter zum Aufbewahren eines ersten Precursors mit niedrigem Dampfdruck, einen Zwischenspeicher zum Zwischenspeichern des aus dem Vorratsbehälter verdampften ersten Precursors, eine erste Gasleitung, die den Vorratsbehälter mit dem Zwischenspeicher verbindet, und eine zweite Gasleitung zur Entnahme des Gases aus dem Zwischenspeicher auf. Die Gasversorgungsvorrichtung wird in dieser Ausführung auch als Gaserzeuger bezeichnet.

Der Vorratsbehälter wird erfindungsgemäß auf einer ersten Temperatur T1 gehalten. Über die erste Gasleitung gelangt das Gas in den Zwischenspeicher, wo es auf einer zweiten Temperatur T2 gehalten wird. Ebenso wird der Druck im Zwischenspeicher auf einem konstanten Druck p2 gehalten, der geringer ist als der Druck p1 im Vorratsbehälter, so daß aufgrund des höheren Drucks im Vorratsbehälter der dampfförmige erste Precursor in den Zwischenspeicher strömt. Erfindungsgemäß ist die erste Temperatur T1 im Vorratsbehälter höher als die zweite Temperatur T2 im Zwischenspeicher.

Die Gasentnahme über die zweite Gasleitung am Zwischenspeicher dient der Versorgung von Beschichtungsanlagen mit dem gasförmigen ersten Precursor. Beschichtungsanlagen sind insbesondere CVD-Beschichtungsanlagen oder dergleichen. Precursoren werden regelmäßig auch als Eduktspezies, Ausgangsstoffe oder schichtbitdendes Material bezeichnet. Unter Precursoren mit geringem Dampfdruck sollen feste oder flüssige, schichtbildende Verbindungen verstanden werden, die z.B. bei Temperaturen von 50°C einen Dampfdruck von weniger als 10 mbar haben.

Ein Vorratsbehälter ist dabei regelmäßig; ein Quarzkolben oder ein Edelstahlbehältnis oder dergleichen, wobei das Behältermaterial resistent gegen Reaktionen mit dem Precursor ist. Der Zwischenspeicher kann ebenfalls aus Quarz, Edelstahl oder dergleichen sein. Der Zwischenspeicher ist vorteilhafterweise großvolumig ausgelegt, um Druckschwankungen bei unregelmäßiger Gasentnahme aus dem Zwischenspeicher zu puffern. Das optimale Volumen eines Zwischenspeichers ist aus der DE 42 36 324 C1 bekannt, deren Offenbarungsinhalt hiermit eingeschlossen ist.

Der maximal aus dem Vorratsbehälter entnehmbare Massenfluß hängt vom Druck p1 ab. Im Normalbetrieb ist das Gasvolumen des Vorratsbehälters mit reinem Precursordampf gefüllt, so daß der Druck p1 gleich dem Gleichgewichtsdampfdruck des Precursors ist. Dieser nimmt mit der Temperatur T1 zu. Der für eine Beschichtungsanlage aus dem Zwischenspeicher maximal entnehmbare Precursor-Massenfluß wird durch den Stoffstrom zwischen dem Vorratsbehälter und dem Zwischenspeicher begrenzt Mit Erhöhung der Temperatur T1 und dem damit ansteigenden Druck p1 läßt sich folglich der für die Beschichtung maximal nutzbare Massenfluß erhöhen.

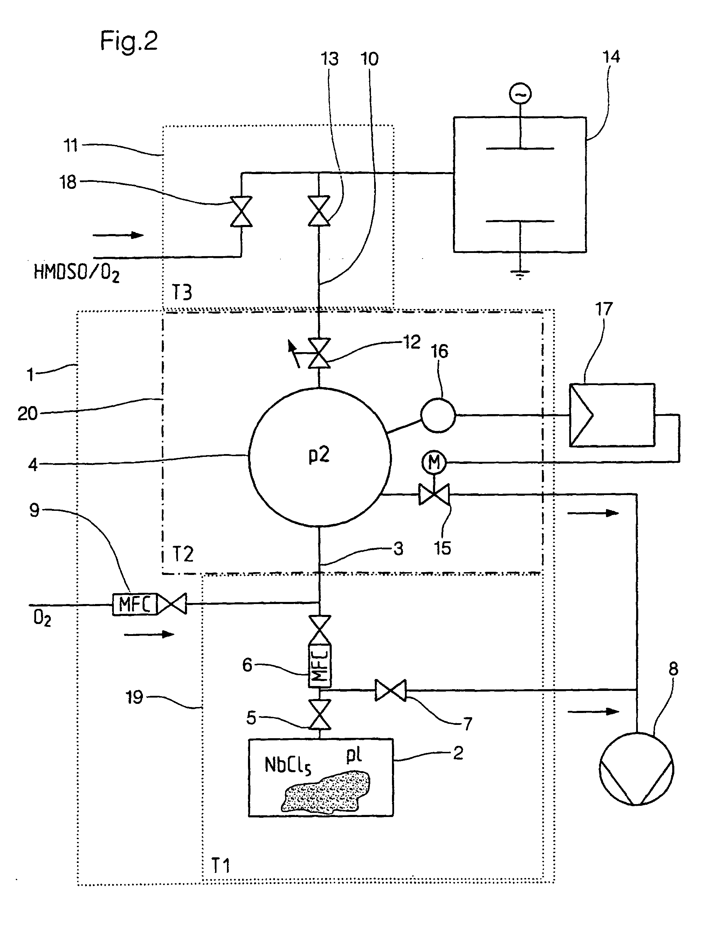

Die Verdampfungsrate des ersten Precursors im Vorratsbehälter hängt von der Temperatur T1 und dem Partialdruck des ersten Precursors im Vorratsbehälter ab. Die Verdampfungsrate nimmt mit steigender Temperatur zu. Wird nun für den Zwischenspeicher der dampfförmige Precursor entnommen, so wird dieser aufgrund der Verdampfung sehr schnell nachgeliefert. Im Vorratsbehälter wird der Sättigungsdampfdruck des Precursors nahezu aufrechterhalten. Da der Sättigungsdampfdruck sehr stark von der Temperatur abhängt (siehe Fig. 2), läßt sich durch eine geringe Änderung der Temperatur T1 eine große Änderung des Drucks p1 erreichen.

Da aufgrund des geringeren Drucks p2 im Zwischenspeicher der Precursor im Zwischenspeicher vorzugsweise nur gasförmig vorliegt, wird der maximal entnehmbare Massenfluß in einem geeigneten Temperaturintervall nicht durch die geringere Temperatur T2 in einem geeigneten Temperaturintervall des Zwischenspeichers begrenzt. Die Temperatur T2 kann daher unabhängig von der Temperatur T1 gewählt werden und der Zwischenspeicher sowie die mit dem Zwischenspeicher verbundenen Einrichtungen müssen nur gegenüber der geringeren Temperatur T2 wärmebeständig sein, was den Einsatz kostengünsiger Komponenten, z.B. Massendurchftußregler und Ventile, ermöglicht. Für Wartungs- oder Reparaturarbeiten im Bereich des Zwischenspeichers wird dadurch die Wartezeit bis zur Abkühlung des Zwischenspeichers und der damit verbundenen Einrichtungen verkürzt.

Weiterhin trägt die geringere Temperatur T2, auf der der großvolumige Zwischenspeicher gehalten werden muß, zur Energieeinsparung bei. Dagegen kann der Vorratsbehälter im Vergleich zum Zwischenspeicher kleine Ausmaße annehmen und wärmeisoliert in den beheizten Bereich des Zwischenspeichers integriert sein.

Es ist vorteilhaft, die Temperatur T2 des Zwischenspeichers so einzustellen, daß der maximale Partialdruck des ersten Precursors im Zwischenspeicher unter dem Sättigungsdampfdruck des Precursors im Zwischenspeicher bei der Temperatur T2 liegt Damit wird vermieden, daß der erste Precursor im Zwischenspeicher kondensiert und dort zurück bleibt.

Wenn der Druck p1 mehr als das 1,5- des Druckes p2 im Zwischenspeicher beträgt, wird ein Druckgefälle zwischen dem Vorratsbehälter und dem Zwischenspeicher erreicht, bei dem eine Verblockung einer Verbindung zwischen dem Vorratsbehälter und dem Zwischenspeicher erreicht wird. Dann hängt die Transportrate explizit von der Druckdifferenz (p1 - p2) und dem Leitwert der Rohrverbindung zwischen dem Vorratsbehälter und dem Zwischenspeicher ab. Im Grenzfall einer ideal verblockten Strömung ist der maximale Stoffmengenstrom allein von p1 und dem Leitungsquerschnitt an der Verblockung (zB. Rohrende oder Ventilöffnung) bestimmt

Durch die Verblockung wird ebenso verhindert, daß der Precursordampf aus dem Zwischenspeicher zurück in den Vorratsbehälter diffundieren kann. In dem Fall, in dem im Zwischenspeicher ein Gasgemisch des Precursordampfs mit einem anderen Gas verwendet wird, wird verhindert, daß sich der Precursor im Vorratsbehälter mit anderen Gasen mischt.

Wird zum Einstellen des Massenflusses z.B. ein Ventil zwischen dem Zwischenspeicher und dem Vorratsbehälter eingesetzt, so kann dessen Leitwert so eingestellt werden, daß der Massenfluß durch das Ventil nur durch den eingangsseitigen Druck p1 beeinflußt wird und unabhängig vom ausgangsseitigen Druck p2 ist (Bedingungen der Verblockung). Vorzugsweise ist der Druck p1 doppelt so hoch wie der Druck p2.

Bei einer vorteilhaften Ausgestaltung der Gasversorgungsvorrichtung wird zwischen dem Vorratsbehälter und dem Zwischenspeicher eine Dosiereinrichtung vorgesehen. Die Dosiereinrichtung dient dem Einstellen des Massenflusses vom Vorratsbehälter zum Zwischenspeicher. Eine Dosiereinrichtung ist dabei regelmäßig eine Düse zur Beschränkung des Leitungsquerschnitts, ein Ventil zum Öffnen und Schließen, ein Dosierventil veränderbaren Querschnitts und dergleichen. Die Dosiereinrichtung dient der Beschränkung des Massenflusses vom Vorratsbehälter zum Zwischenspeicher. Vorzugsweise wird die Dosiereinrichtung so gesteuert, z.B. durch einen Regler, daß der Massenfluß erhöht wird, wenn der Druck im Zwischenspeicher unter den konstanten Druck p2 fällt, und der Massenfluß verringert wird, wenn der Druck im Zwischenspeicher p2 übersteigt.

Die erste Dosiereinrichtung ist vorteilhafterweise ein steuerbarer Massendurchflußregler, so daß einerseits eine Steuerung über eine Steuereinheit oder einen Regler erfolgen kann und andererseits der zwischen dem Vorratsbehälter und dem Zwischenspeicher fließende Massenstrom gemessen werden kann.

Gemäß einer weiteren Ausgestaltung der Verwendung der Gasversorgungsvorrichtung wird über eine zweite Dosiereinrichtung Gas aus dem Zwischenspeicher zu einem Gasauslaß ausgelassen. Damit kann kontinuierlich Gas aus dem Zwischenspeicher abgelassen werden. Alternativ kann die zweite Dosiereinrichtung so geregelt werden, daß bei Überschreiten des Drucks p2 Gas aus dem Zwischenspeicher ausgelassen werden kann, um den Druck im Zwischenspeicher konstant zu halten. Der Auslaß kann ebenfalls zum Evakuieren und Spülen des Zwischenspeichers verwendet werden.

Die zweite Dosiereinrichtung kann vorteilhaft ein Drosselventil sein, bei dem sich der Querschnitt zum Auslassen des Gases regulieren läßt.

Gemäß einer weiteren Ausgestaltung ist der Gasauslaß mit einer Vakuumpumpe und/oder Kältefalle verbunden. Die Vakuumpumpe evakuiert die Austrittseite des Gasauslasses auf einen Druck unter dem Druck p2 des Zwischenspeichers, so daß ein Druckgefälle entsteht und Gas ausgelassen werden kann. Alternativ kann die Vakuumpumpe und die Kältefalle gemeinsam verwendet werden, so daß das kondensierbare Gas an der Kältefalle ausfriert, während nicht kondensierbare Gase von der Vakuumpumpe abgesaugt werden. Durch den Einsatz der Kältefalle ist es möglich, die meist teuren Precursoren mit niedrigem Dampfdruck zurückzuhalten, um diese einer Weiterverwendung zuzuführen.

Bei einer besonders vorteilhaften Ausgestaltung der Gasversorgungsvorrichtung wird in die erste Gasleitung zwischen Vorratsbehälter und Zwischenspeicher ein Trägergas eingespeist Das Trägergas kann ein Inertgas, ein zweiter Precursor oder ein Gasgemisch mit einem zweiten Precursor sein. Trägergase werden bei CVD-Prozessen eingesetzt, um die Precursoren schneller an den zu beschichtenden Gegenstand zu transportieren und von dort Reaktionsprodukte oder Verunreinigungen abzutransportieren. Das Trägergas transportiert somit den ersten Precursor schneller durch die Gasversorgungsvorrichtung. Dabei bewirkt das Mischen des ersten Precursors mit dem Trägergas den zusätzlichen, vorteilhaften Effekt, daß durch die Verdünnung des ersten Precursors dessen Partialdruck im Zwischenspeicher geringer als der Gesamtdruck p2 im Zwischenspeicher ist. Dies erlaubt eine weitere Absenkung der Temperatur T2 des Zwischenspeichers, da die Kondensation des Precursors allein vom Partialdruck des ersten Precursors und nicht vom Gesamtdruck im Zwischenspeicher abhängt. Durch die Erniedrigung des Partialdrucks im Zwischenspeicher kann die Temperatur T2 noch weiter verringert werden. Die Temperatur T2 wird durch die untere Grenze beschränkt, bei der der temperaturabhängige Sättigungsdampfdruck oberhalb des Partialdrucks des ersten Precursors im Zwischenspeicher liegt, wodurch eine Kondensation vermieden wird.

Bei dieser Ausgestaltung wird im Zwischenspeicher ein Gemisch gespeichert, dessen Precursor-Konzentration (bzw. Molenbruch) konstant eingestellt wird. Dies wird durch die Einstellung eines konstanten Verhältnisses zwischen beiden einströmenden Gasflüssen (Precursor und Transport-/Reaktionsgas) gewährleistet. Durch die Herstellung der oben beschriebenen Verblockung zwischen dem Vorratsbehälter und dem Zwischenspeicher ist bei konstantem Druck p1 ein definierter Massenfluß vom Vorratsbehälter zum Zwischenspeicher gewährleistet. Zusätzlich wird durch die Verblockung die Rückdiffusion des Gasgemisches vom Zwischenspeicher in den Vorratsbehälter verhindert.

Die Zufuhr des Trägergases erfolgt praktischerweise nach der ersten Dosiereinrichtung, so daß der durch die Dosiereinrichtung strömende Massenfluß ausschließlich den Precursor enthält und aufgrund des Druckgefälles über die Dosiereinrichtung kein Trägergas in den Vorratsbehälter strömt.

Bei einer weiteren Ausgestaltung wird das Trägergas über eine dritte Dosiereinrichtung eingespeist, die vorteilhafterweise ein Massendurchflußregler ist, so daß der Massenzufluß des Trägergases regulierbar ist.

Bei einer besonders vorteilhaften Ausgestaltung wird der Massenfluß des Trägergases proportional abhängig vom Massenfluß des ersten Precursors vom Vorratsbehälter zum Zwischenspeicher eingestellt. Dadurch wird im Zwischenspeicher ein über den Proportionalitätsfaktor vorgegebenes Mischungsverhältnis des ersten Precursors mit dem Trägergas vorgegeben. Das konstante Mischungsverhältnis im Zwischenspeicher ermöglicht eine definierte Zufuhr des ersten Precursors zur Beschichtungsanlage und damit letztlich eine gleichmäßige Abscheiderate.

Für die Herstellung von optischen Funktionsschichten mit einer Nioboxidschicht ist der erste Precursor vorzugsweise eine Nb-Verbindung, vorzugsweise NbCl₅ oder ein Nb-Alkoholat, und das Trägergas ist vorzugsweise O₂. Werden z.B. SiO₂-/Nb₂O₅ Wechselschichten hergestellt, so stehen bei einer Gasmischung von O₂ und NbCl₅ im Zwischenspeicher unmittelbar die Reaktionsgase zur Abscheidung der Nb₂O₅-Schicht zur Verfügung ohne daß ein weiteres Gas als Trägergas verwendet werden muß.

Für Schichten, die Tantal enthalten, können vorzugsweise TaCl₅ oder ein Ta-Alkoholat verwendet werden. Für Schichten, die Titan oder Aluminium enthalten, können vorzugsweise TIPT (Titan-Isopropylat) oder AlCl₃ verwendet werden.

Anhand von Zeichnungen wird ein Ausführungsbeispiel der Erfindung näher erläutert.

Es zeigen:
- Fig. 1: ein Diagramm der Temperaturabhängigkeit des Sättigungsdampfdrucks eines NbCl₅-Precursors,
- Fig. 2: ein Ausführungsbeispiel der Gasversorgungsvorrichtung und eine Gaswechselstation sowie eine CVD-Abscheideanlage, und
- Fig. 3: eine Kombination von zwei Gasversorgungsvorrichtungen mit zwei Beschichtungsanlagen, die über eine Gaswechselstation miteinander verbunden sind.

In der unteren Kurve des Diagramms von Fig. 1 ist der Verlauf des Sättigungsdampfdrucks von NbCl₅ in Abhängigkeit von der Temperatur dargestellt. Niobpentachlorid (NbCl₅) liegt über den dargestellten Temperaturbereich als Festkörper vor, der unmittelbar in die Gasphase sublimiert. Die untere Kurve des Diagramms zeigt den Sättigungsdampfdruck an, den der Partialdruck des NbCl₅ in der Gasphase im Gleichgewicht mit der festen Phase maximal erreichen kann. Bei 50°C liegt der Sättigungsdampfdruck bei ungefähr 0,04 mbar. Dieser Druck ist zu gering, um einen ausreichenden Massenstrom des NbCl₅ im gasförmigen Zustand durch die Rohrleitungen und Ventile eines Gasversorgungssystems zu erreichen. Um eine ausreichende Gasmenge zur Verfügung zu stellen und um diese durch ein Leitungssystem zu transportieren, muß die Temperatur und damit der Sättigungsdampfdruck erhöht werden.

Die obere Kurve in Fig. 1 zeigt den maximal einstellbaren Gesamtdruck bzw. Absolutdruck für den Fall, daß NbCl₅ mit einem anderen Gas auf 5% NbCl₅-Anteil verdünnt vorliegt Der Gesamtdruck kann dann ca. 20mal höher liegen als der Sättigungsdampfdruck des NbCl₅, bevor NbCl₅ aus diesem Gasgemisch kondensiert.

Fig. 2 zeigt schematisch eine Gasversorgungsvorrichtung 1, bei der der Precursor NbCl₅ in einem Vorratsbehälter 2 gelagert ist. Durch das Verdampfen des Precursors stellt sich im Vorratsbehälter 2 ein erster Druck p1 ein. Der Vorratsbehälter 2 ist über eine erste Gasleitung 3 mit einem Zwischenspeicher 4 verbunden. In der ersten Gasleitung 3 sind vom Vorratsbehälter 2 kommend ein erstes Absperrventil 5 und ein Massendurchflußregler 6 (MFC) angeordnet. Mit dem ersten Absperrventil 5 kann die erste Gasleitung 3 zum Vorratsbehälter 2 hin abgesperrt werden, so daß der Vorratsbehälter 2 für Wartungsarbeiten oder zum Nachfüllen des Precursors NbCl₅ aus der Gasversorgungsvorrichtung 1 entnommen werden kann.

Während des Gasversorgungsbetriebes dient der erste Massendurchflußregler 6 zum Messen des Massenflusses vom Vorratsbehälter 2 zum Zwischenspeicher 4 und zum Einregeln des Massendurchflusses auf einen vorgegebenen Wert.

Zwischen dem ersten Absperrventil 5 und dem ersten Massendurchflußregler 6 zweigt von der ersten Gasleitung 3 eine weitere Gasleitung ab, die sich mit einem zweiten Absperrventil 7 absperren läßt. Bei geöffnetem Absperrventil 7 und geöffnetem Absperrventil 5 kann der Vorratsbehälter 2 durch eine Vorpumpe 8 evakuiert werden. Ebenso kann zugeführtes Spülgas, dessen Zufuhr nicht dargestellt ist, über die Vorpumpe 8 abgepumpt werden.

Zwischen dem ersten Massendurchflußregler 6 und dem Zwischenspeicher 4 mündet eine weitere Leitung in die erste Gasleitung 3. In dieser Leitung ist ein zweiter Massendurchflußregler 9 angeordnet. Durch den zweiten MassendurchfluBregler 9 kann in die erste Gasleitung 3 ein Trägergas oder ein weiteres Reaktionsgas, im vorliegenden Fall Sauerstoff (O₂), eingeleitet werden. Dadurch wird der Precursor NbCl₅ mit dem Trägergas gemischt und in den Zwischenspeicher 4 eingeleitet.

Über eine zweite Gasleitung 10 kann aus dem Zwischenspeicher 4 das Gas oder Gasgemisch entnommen und einer Gaswechselstation 11 zugeführt werden. Ausgehend vom Zwischenspeicher 4 sind in der zweiten Gasleitung 10 ein erstes Dosierventil 12 und ein drittes Absperrventil 13 angeordnet, bevor die zweite Gasleitung 10 in eine Abscheideanlage 14 mündet. Bei geöffnetem dritten Absperrventil 13 bewirkt das erste Dosierventil 12 einen Druckabfall zwischen dem Zwischenspeicher 4 und der Ausgangsseite des ersten Dosierventils 12.

Aus dem Zwischenspeicher 4 führt eine weitere Gasleitung über ein Drosselventil 15 heraus, die ebenfalls mit der Vorpumpe 8 verbunden ist. Der Druck im Zwischenspeicher 4 wird mit einem Drucksensor 16 gemessen. Der gemessene Druckwert wird einem Druckregler 17 zugeführt, der das Drosselventil 15 ansteuert. Der Druckregler 17 hält den Druck im Zwischenspeicher 4 auf einem vorgegebenen zweiten Druckwert p2. Überschreitet der Druck im Zwischenspeicher 4 den vorgegebenen zweiten Druckwert p2, so steuert der Druckregler 17 das Drosselventil 15 an, um dieses zu öffnen und überschüssiges Gas zur Vorpumpe 8 hin abzuleiten.

In der Gaswechselstation 11 kann hinter dem dritten Absperrventils in die zweite Gasleitung 10 aus einer weiteren Gasleitung über ein viertes Absperrventil 18 wahlweise ein anderes Abscheidegas eingeleitet werden. im vorliegenden Fall ist das andere Abscheidegas ein Hexamethyldisiloxan/Sauerstoff-Gemisch (HMDSO/O₂) für die Abscheidung von SiO₂-Schichten. Damit kann durch Umschalten der Absperrventile 13 und 18 der Abscheidebetrieb von einer Nb₂O₅- Abscheidung (aus dem Precursor NbCl₅) auf eine SiO₂-Abscheidung umgestellt werden.

Die Gasversorgungsvorrichtung 1 ist in zwei Temperaturzonen unterteilt. Die erste Temperaturzone ist der Vorratsbereich 19, der den Vorratsbehälter 2, das erste Absperrventil 5, einen Teil der ersten Gasleitung 3, den ersten Massendurchflußregler 6, das zweite Absperrventil 7 sowie ein Teil der zuund abführenden Gasleitungen umfaßt. Der Vorratsbereich 19 wird auf einer ersten Temperatur T1 konstant gehalten. Die Heizung erfolgt durch übliche Heiztechniken. Die Temperatur wird vorzugsweise durch eine Regelung konstant gehalten. Durch die erste Temperatur T1 stellt sich im Vorratsgefäß der Sättigungsdampfdruck p1 des ersten Precursors, hier NbCl₅, ein. Durch das Heizen der mit dem Vorratsbehälter 2 verbundenen Elemente wird eine Kondensation im Vorratsbereich 19 vermieden.

Weiterhin wird ein Zwischenspeicherbereich 20, der einen Teil der ersten Gasleitung 3, den Zwischenspeicher 4, einen Teil der zweiten Gasleitung 10, das erste Dosierventil 12, den Drucksensor 16, das Drosselventil 15 sowie evtl. Gasleitungen zum Spülen oder Zuführen weiterer Gase umfaßt, auf einer zweiten Temperatur T2 gehalten.

Beim Ausführungsbeispiel wird durch den zweiten Massendurchflußregler 9 . Sauerstoff in die erste Gasleitung 3 eingespeist. Durch eine entsprechende Ansteuerung der Massendurchflußregler 6 und 9 wird erreicht, daß der zweite Massendurchflußregler 9 einen zum ersten Massendurchflußregler 6 proportionalen Massenstrom des Sauerstoffs einleitet. Vorliegend beträgt der Massenstrom des Sauerstoffs das 19fache des Massenstroms des NbCl₅. Dadurch wird im Zwischenspeicher 4 ein Mischungsverhältnis von 5% NbCl₅-Gas zu 95% Sauerstoff erreicht. Der Zwischenspeicher wird auf einen Gesamtdruck von 40 mbar gehalten. Dabei beträgt der Partialdruck des NbCl₅ im Zwischenspeicher ca. 2 mbar, was deutlich unter dem Sättigungsdampfdruck von 4 mbar bei 120°C liegt (siehe Fig. 1) und eine Kondensation des NbCl₅ verhindert wird.

Die erste Temperatur T2 ist gleich 200°C, so daß der Sättigungsdampfdruck des NbCl₅ nach Fig. 1 ca. 105 mbar beträgt und somit p1 bei ungefähr 100 mbar liegt Damit besteht zwischen dem Vorratsbehälter 2 und dem Zwischenspeicher 4 ein Druckgefälle mit einem Faktor größer 2, so daß der Massenstrom vom Vorratsbehälter 2 in den Zwischenspeicher 4 gewährleistet ist.

Die Regelung des Drucks p2 im Zwischenspeicher 4 erfolgt durch das Drosselventil 15. Bei den Massendurchflußreglern sind dabei konstante Durchflüsse eingestellt. Alternativ erfolgt die Druckregelung für p2 bei einem fest eingestellten Öffnungsquerschnitt des Drosselventils 15 zur Vorpumpe 8 durch eine variable Regelung der Massendurchflüsse der Massendurchflußregler 6, 9 in einem konstanten Verhältnis.

Durch das erste Dosierventil 12 zwischen dem Zwischenspeicher und der Gaswechselstation erfolgt ein weiterer Druckabfall. Dadurch wird der Partialdruck des NbCl₅ weiter reduziert und die Temperatur im Bereich der Gaswechselstation kann weiter herabgesetzt werden. Vorliegend beträgt sie 75°C, so daß nach Fig. 1 der maximale Partialdruck des NbCl₅ 0,25 mbar betragen kann und damit der Gesamtdruck des Gasgemischs maximal 5 mbar. Von dem Zwischenspeicherbereich 20 zur Gaswechselstation 11 fällt damit der Druck um mindestens den Faktor 8 ab. Bei diesem Druckgefälle findet in dem ersten Dosierventil 12 eine Verblockung statt, d.h. bei diesem Druckgefälle hängt der Massendurchfluß durch das erste Dosierventil nur von dessen Leitwert und dem Druck p2 im Zwischenspeicher 4 ab und ist unabhängig vom Druck in der Gaswechselstation 11. Um einen konstanten Massendurchfluß vom Zwischenspeicher 4 zur Gaswechselstation 11 und weiter in die Abscheideanlage 14 zu erhalten, ist es somit nicht notwendig einen weiteren Massendurchftußregler vorzusehen, weil der Massendurchfluß über den konstant gehaltenen Druck p2 und den eingestellten Leitwert des ersten Dosierventils festgelegt ist.

Bei einer anderen Ausführung der Gasversorgungsvorrichtung kann auch der erste Massendurchflußregler 6 durch ein Dosierventil entsprechend dem ersten Dosierventil 12 ersetzt werden, da auch hier der Druckabfall zwischen dem Vorratsbehälter 2 und dem Zwischenspeicher 4 mehr als einen Faktor 2 beträgt. Dadurch läßt sich der Hochtemperatur-Massendurchflußregler 6 durch ein günstigeres Dosierventil ersetzen.

Die obige Gasversorgungsvorrichtung 1 wurde nur beispielhaft für die Verwendung des Precursors NbCl₅ und des Trägergases Sauerstoff beschrieben. Andere Precursoren mit niedrigem Dampfdruck und andere Trägergase können ebenfalls verwendet werden. Beispiele für Precursoren sind Niob-Ethoxid, Aluminiumtrichlorid, Titan-Isopropoxid, Tantal-Ethoxid. Die einzustellenden Temperaturen T1 für den Vorratsbereich 19, T2 für den Zwischenspeicherbereich 20 und T3 für die Gaswechselstation können dann anhand der Sättigungsdampfdruck-Kurven des jeweiligen Precursors unter Berücksichtigung der einzelnen Konzentrationen (Molenbrüche) ermittelt werden.

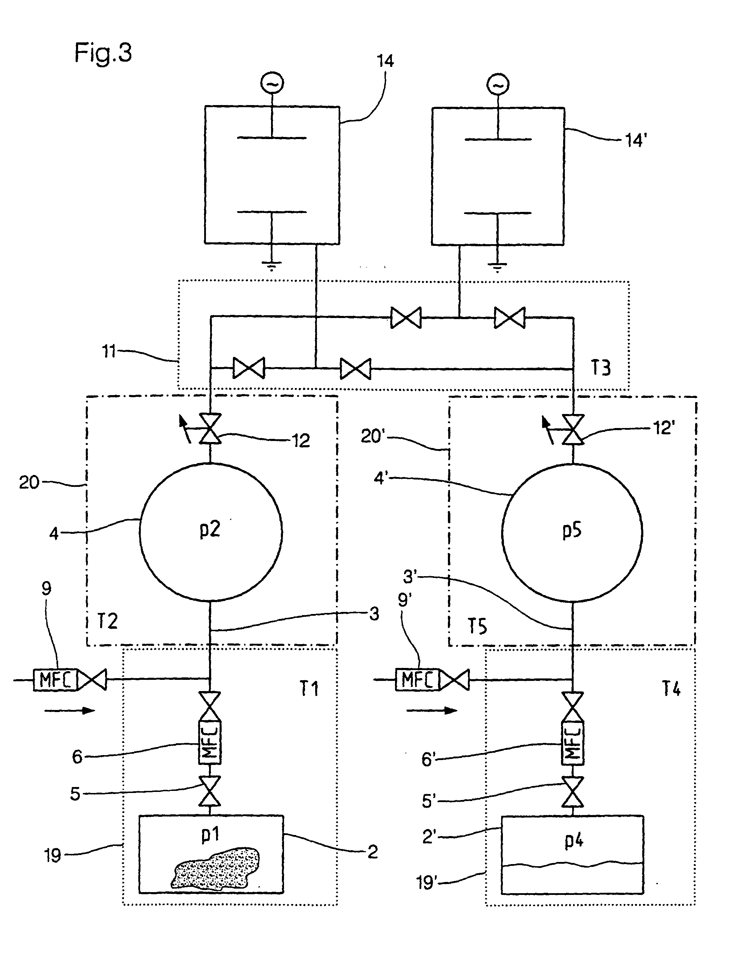

Fig. 3 zeigt eine Mehrkammerbeschichtungsanlage 14; 14', die über eine Gaswechselstation 11 aus mehreren Gasversorgungsvorrichtungen 19, 20; 19', 20' mit zwei verschiedenen Precursoren zur Herstellung von Wechselschichten versorgt werden können. Die in Fig. 2 dargestellten Bezugszeichen, die oben beschrieben sind, werden für gleiche Elemente in Fig. 3 verwendet.

Die Funktionsweise der beiden Gasversorgungsvorrichtungen 19, 20; 19', 20' entspricht im wesentlichen der Gasversorgungsvorrichtung 1 von Fig. 2, mit dem Unterschied, daB die Temperatur T1 des Vorratsbereichs 19 und die Temperatur T2 des Zwischenspeicherbereichs 20 für die Temperaturabhängigkeit des Precursors im Vorratsbehälter 2 optimiert sind und die Temperatur T4 im Vorratsbereich 19' und die Temperatur T5 im Zwischenspeicherbereich 20' für den temperaturabhängigen Verlauf des Dampfdrucks des zweiten Precursors im Vorratsbehälter 2' optimiert sind.

### Bezugszeichenliste

- 1: Gasversorgungsvorrichtung
- 2: Vorratsbehälter
- 3: erste Gasleitung
- 4: Zwischenspeicher
- 5: erstes Absperrventil
- 6: erster Massendurchflussregler
- 7: zweites Absperrventil
- 8: Vorpumpe
- 9: zweiter Massendurchflussregler
- 10: zweite Gasleitung
- 11: Gaswechselstation
- 12: erstes Dosierventil
- 13: drittes Absperrventil
- 14: Abscheideanlage
- 15: Drosselventil
- 16: Drucksensor
- 17: Druckregler
- 18: viertes Absperrventil
- 19: Vorratsbereich
- 20: Zwischenspeicherbereich

## Patentansprüche

1. Verwendung einer Gasversorgungsvorrichtung für Precursoren geringen Dampfdrucks, insbesondere für CVD-Beschichtungsanlagen, mit
einem Vorratsbehälter (2) für einen ersten Precursor mit niedrigem Dampfdruck, wobei der Vorratsbehälter (2) mit dem Precursor auf einer ersten Temperatur T1 gehalten wird,
einem Zwischenspeicher (4) zum Zwischenspeichern des dampfförmigen ersten Precursors, wobei der Zwischenspeicher (4) auf einer zweiten Temperatur T2 und einem konstanten Druck p2, der niedriger als ein Druck p1 in dem Vorratsbehälter (2) ist, gehalten wird, einer ersten Gasleitung (3) zwischen dem Vorratsbehälter (2) und dem Zwischenspeicher (4), und
einer zweiten Gasleitung (10) am Zwischenspeicher (4) zur Entnahme von Gas aus dem Zwischenspeicher (4),
**dadurch gekennzeichnet, daß** die erste Temperatur T1 höher als die zweite Temperatur T2 ist.

2. Verwendung einer Gasversorgungsvorrichtung nach Anspruch 1, **dadurch gekennzeichnet, daß** die Temperatur T2 in dem Zwischenspeicher (4) so eingestellt ist, daß der Sättigungsdampfdruck des ersten Precursors über dessen Partialdruck im Zwischenspeicher (4) liegt.

3. Verwendung einer Gasversorgungsvorrichtung nach Anspruch 1 oder 2, **dadurch gekennzeichnet, daß** der Druck p1 des ersten Precursors in dem Vorratsbehälter (2) der Sättigungsdampfdruck ist und der erste Precursor in einem Gleichgewicht zwischen der flüssigen oder festen Phase und der dampfförmigen Phase steht.

4. Verwendung einer Gasversorgungsvorrichtung nach Anspruch 3, **dadurch gekennzeichnet, daß** die Temperatur T1 des Vorratsbehälters (2) so eingestellt ist, daß der Druck p1 des ersten Precursors in dem Vorratsbehälter (2) das 1,5 bis 10-fache des Drucks p2 beträgt.

5. Verwendung einer Gasversorgungsvorrichtung nach Anspruch 4, **dadurch gekennzeichnet, daß** der Druck p1 ungefähr das zweifache des Drucks p2 beträgt.

6. Verwendung einer Gasversorgungsvorrichtung nach einem der Ansprüche 1 bis 5, **dadurch gekennzeichnet, daß** zwischen dem Vorratsbehälter (2) und dem Zwischenspeicher (4) eine erste Dosiereinrichtung (6) zum Einstellen des Massenflusses von dem Vorratsbehälter (2) zum Zwischenspeicher (4) angeordnet ist.

7. Verwendung einer Gasversorgungsvorrichtung nach Anspruch 6, **dadurch gekennzeichnet, daß** die erste Dosiereinrichtung (6) ein steuerbarer Massendurchflußregler ist.

8. Verwendung einer Gasversorgungsvorrichtung nach einem der Ansprüche 1 bis 7, **dadurch gekennzeichnet, daß** der Zwischenspeicher (4) über eine zweite Dosiereinrichtung (15) an einen Gasauslaß gekoppelt ist.

9. Verwendung einer Gasversorgungsvorrichtung nach Anspruch 8, **dadurch gekennzeichnet, daß** die zweite Dosiereinrichtung (15) ein Drosselventil ist

10. Verwendung einer Gasversorgungsvorrichtung nach Anspruch 8 oder 9, **dadurch gekennzeichnet, daß** der Gasauslaß mit einer Vakuumpumpe (8) und/oder Kältefalle verbunden ist.

11. Verwendung einer Gasversorgungsvorrichtung nach einem der Ansprüche 8 bis 10, **dadurch gekennzeichnet, daß** der konstante Druck p2 in dem Zwischenspeicher (4) durch die zweite Dosiereinrichtung (15) eingestellt wird.

12. Verwendung einer Gasversorgungsvorrichtung nach einem der Ansprüche 1 bis 11, **dadurch gekennzeichnet, daß** in die erste Gasleitung (3) zwischen dem Vorratsbehälter (2) und dem Zwischenspeicher (4) ein Trägergas einleitbar ist.

13. Verwendung einer Gasversorgungsvorrichtung nach einem der Ansprüche 6 bis 11, **dadurch gekennzeichnet, daß** in die erste Gasleitung (3) zwischen der ersten Dosiereinrichtung (6) und dem Zwischenspeicher (4) ein Trägergas einleitbar ist.

14. Verwendung einer Gasversorgungsvorrichtung nach Anspruch 12 oder 13, **dadurch gekennzeichnet, daß** das Trägergas über eine dritte Dosiereinrichtung (9) eingeleitet wird.

15. Verwendung einer Gasversorgungsvorrichtung nach Anspruch 14, **dadurch gekennzeichnet, daß** die dritte Dosiereinrichtung (9) ein Massendurchflußregler ist.

16. Verwendung einer Gasversorgungsvorrichtung nach einem der Ansprüche 14 oder 15, **dadurch gekennzeichnet, daß** der konstante Druck p2 durch die Massenflüsse der ersten und dritten Dosiereinrichtung (6, 9) bei festgelegtem Öffnungsquerschnitt der zweiten Dosiereinrichtung (15) eingestellt wird.

17. Verwendung einer Gasversorgungsvorrichtung nach einem der Ansprüche 12 bis 16, **dadurch gekennzeichnet, daß** der Massenfluß des Trägergases proportional zum Massenfluß des ersten Precursors vom Vorratsbehälter (2) zum Zwischenspeicher (4) ist.

18. Verwendung einer Gasversorgungsvorrichtung nach einem der Ansprüche 1 bis 17, **dadurch gekennzeichnet, daß** der Precursor eine Nb-, Ta-, Ti- oder Al-Verbindung ist

19. Verwendung einer Gasversorgungsvorrichtung nach Anspruch 18, **dadurch gekennzeichnet, daß** die Nb-Verbindung NbCl₅ oder Nb-Ethoxid ist.

20. Verwendung einer Gasversorgungsvorrichtung nach Anspruch 18, **dadurch gekennzeichnet, daß** die Ta-Verbindung TaCl₅ oder Ta-Ethoxid ist.

21. Verwendung einer Gasversorgungsvorrichtung nach Anspruch 18, **dadurch gekennzeichnet, daß** die Al-Verbindung AlCl₃ ist.

22. Verwendung einer Gasversorgungsvorrichtung nach Anspruch 18, **dadurch gekennzeichnet, daß** die Ti-Verbindung TIPT (Titan-Isopropylat) ist.

23. Verwendung einer Gasversorgungsvorrichtung nach einem der Ansprüche 12 bis 22, **dadurch gekennzeichnet, daß** das Trägergas ein Inertgas, ein zweiter Precursor oder ein Gasgemisch mit einem zweiten Precursor ist, wobei jedes der Trägergase unter Normalbedingungen gasförmig ist.

24. Verwendung einer Gasversorgungsvorrichtung nach Anspruch 23, **dadurch gekennzeichnet, daß** das Trägergas Sauerstoff ist oder enthält

## Claims

1. Use of a gas supply apparatus for precursors of low vapor pressure, especially for CVD coating systems, with a storage container (2) for a first precursor with a low vapor pressure, with the storage container (2) with the precursor being held at a first temperature T1, an intermediate storage (4) for the intermediate storage of the vapor-like first precursor, with the intermediate storage (4) being held at a second temperature T2 and a constant pressure p2 which is lower than a pressure p1 in the storage container (2), a first gas line (3) between the storage container (2) and the intermediate storage (4), and a second gas line (10) on the intermediate storage (4) for removing gas from the intermediate storage (4), **characterized in that** the first temperature T1 is higher than the second temperature T2.

2. Use of a gas supply apparatus in accordance with claim 1, **characterized in that** the temperature T2 in the intermediate storage (4) is set in such a way that the saturated vapor pressure of the first precursor is above its partial pressure in the intermediate storage (4).

3. Use of a gas supply apparatus in accordance with claim 1 or 2, **characterized in that** the pressure p1 of the first precursor in the storage container (2) is the saturated vapor pressure and the first precursor is in an equilibrium between the liquid or solid phase and the vapor phase.

4. Use of a gas supply apparatus in accordance with claim 3, **characterized in that** the temperature T1 of the storage container (2) is set in such a way that the pressure p1 of the first precursor in the storage container (2) is 1.5 to 10 times the pressure p2.

5. Use of a gas supply apparatus in accordance with claim 4, **characterized in that** the pressure p1 is approximately two times the pressure p2.

6. Use of a gas supply apparatus in accordance with one of the claims 1 to 5, **characterized in that** a first dosing device (6) for setting the mass flow from the storage container (2) to the intermediate storage (4) is arranged between the storage container (2) and the intermediate storage (4).

7. Use of a gas supply apparatus in accordance with claim 6, **characterized in that** the first dosing device (6) is a controllable mass flow controller.

8. Use of a gas supply apparatus in accordance with one of the claims 1 to 7, **characterized in that** the intermediate storage (4) is coupled via a second dosing device (15) to a gas outlet.

9. Use of a gas supply apparatus in accordance with claim 8, **characterized in that** the second dosing device (15) is a throttle valve.

10. Use of a gas supply apparatus in accordance with claim 8 or 9, **characterized in that** the gas outlet is connected with a vacuum pump (8) and/or cold trap.

11. Use of a gas supply apparatus in accordance with one of the claims 8 to 10, **characterized in that** the constant pressure p2 is set in the intermediate storage by the second dosing device (15).

12. Use of a gas supply apparatus in accordance with one of the claims 1 to 11, **characterized in that** a carrier gas can be introduced into the first gas line (3) between the storage container (2) and the intermediate storage (4).

13. Use of a gas supply apparatus in accordance with one of the claims 6 to 11, **characterized in that** a carrier gas can be introduced into the first gas line (3) between the first dosing device (6) and the intermediate storage (4).

14. Use of a gas supply apparatus in accordance with claim 12 or 13, **characterized in that** the carrier gas is introduced via a third dosing device (9).

15. Use of a gas supply apparatus in accordance with claim 14, **characterized in that** the third dosing device (9) is a mass flow controller.

16. Use of a gas supply apparatus in accordance with one of the claims 14 or 15, **characterized in that** the constant pressure p2 is set by the mass flows of the first and third dosing device (6, 9) with a fixed opening cross section of the second dosing device (15).

17. Use of a gas supply apparatus in accordance with one of the claims 12 to 16, **characterized in that** the mass flow of the carrier gas is proportional to the mass flow of the first precursor from the storage container (2) to the intermediate storage (4).

18. Use of a gas supply apparatus in accordance with one of the claims 1 to 17, **characterized in that** the precursor is an Nb, Ta, Ti or Al compound.

19. Use of a gas supply apparatus in accordance with claim 18, **characterized in that** the Nb compound is NbCl₅ or Nb ethoxide.

20. Use of a gas supply apparatus in accordance with claim 18, **characterized in that** the Ta compound is TaCl₅ or Ta ethoxide.

21. Use of a gas supply apparatus in accordance with claim 18, **characterized in that** the Al compound is AlCl₃.

22. Use of a gas supply apparatus in accordance with claim 18, **characterized in that** the Ti compound is TIPT (titanium isopropylate).

23. Use of a gas supply apparatus in accordance with one of the claims 12 to 22, **characterized in that** the carrier gas is an inert gas, a second precursor or a gas mixture with a second precursor, with each of the carrier gases being gaseous under normal conditions.

24. Use of a gas supply apparatus in accordance with claim 23, **characterized in that** the carrier gas is or contains oxygen.

## Revendications

1. Utilisation d'un dispositif d'alimentation en gaz pour précurseurs à basse pression de vapeur, notamment pour des bancs de dépôt en phase vapeur, avec
un réservoir (2) pour un premier précurseur à basse pression de vapeur, le réservoir (2) contenant le précurseur étant maintenu à une première température T1,
un réservoir intermédiaire (4) destiné à contenir provisoirement le premier précurseur sous forme de vapeur, ce réservoir intermédiaire (4) étant maintenu à une deuxième température T2 et à une pression constante p2 inférieure à une pression p1 dans le réservoir (2),
une première conduite de gaz (3) entre le réservoir (2) et le réservoir intermédiaire (4) et
une deuxième conduite de gaz (10) raccordée au réservoir intermédiaire (4) pour prélever du gaz du réservoir intermédiaire (4), **caractérisée en ce que** la première température T1 est supérieure à la deuxième température T2.

2. Utilisation d'un dispositif d'alimentation en gaz selon la revendication 1, **caractérisée en ce que** la température T2 dans le réservoir intermédiaire (4) est réglée de telle sorte que la pression de vapeur saturante du premier précurseur est supérieure à sa pression partielle dans le réservoir intermédiaire (4).

3. Utilisation d'un dispositif d'alimentation en gaz selon la revendication 1 ou 2, **caractérisée en ce que** la pression p1 du premier précurseur dans le réservoir (2) est la pression de vapeur saturante et que le premier précurseur est en équilibre entre la phase liquide ou solide et la phase vapeur.

4. Utilisation d'un dispositif d'alimentation en gaz selon la revendication 3, **caractérisée en ce que** la température T1 du réservoir (2) est réglée de telle sorte que la pression p1 du premier précurseur dans le réservoir (2) est 1,5 à 10 fois supérieure à la pression p2.

5. Utilisation d'un dispositif d'alimentation en gaz selon la revendication 4, **caractérisée en ce que** la pression p1 est environ le double de la pression p2.

6. Utilisation d'un dispositif d'alimentation en gaz selon l'une quelconque des revendications 1 à 5, **caractérisée en ce qu'**un premier système de dosage (6) pour régler le flux massique depuis le réservoir (2) vers le réservoir intermédiaire (4) est disposé entre le réservoir (2) et le réservoir intermédiaire (4)

7. Utilisation d'un dispositif d'alimentation en gaz selon la revendication 6, **caractérisée en ce que** le premier système de dosage (6) est un limiteur de débit massique commandable.

8. Utilisation d'un dispositif d'alimentation en gaz selon l'une quelconque des revendications 1 à 7, **caractérisée en ce que** le réservoir intermédiaire (4) est raccordé à une sortie des gaz par l'intermédiaire d'un deuxième système de dosage (15).

9. Utilisation d'un dispositif d'alimentation en gaz selon la revendication 8, **caractérisée en ce que** le deuxième système de dosage (15) est un clapet avec étranglement.

10. Utilisation d'un dispositif d'alimentation en gaz selon la revendication 8 ou 9, **caractérisée en ce que** la sortie des gaz est reliée à une pompe à vide (8) et/ou à un piège froid.

11. Utilisation d'un dispositif d'alimentation en gaz selon l'une quelconque des revendications 8 à 10, **caractérisée en ce que** la pression constante p2 dans le réservoir intermédiaire (4) est réglée par le deuxième système de dosage (15).

12. Utilisation d'un dispositif d'alimentation en gaz selon l'une quelconque des revendications 1 à 11, **caractérisée en ce qu'**un gaz porteur est susceptible d'être introduit dans la première conduite de gaz (3) entre le réservoir (2) et le réservoir intermédiaire (4).

13. Utilisation d'un dispositif d'alimentation en gaz selon l'une quelconque des revendications 6 à 11, **caractérisée en ce qu'**un gaz porteur est susceptible d'être introduit dans la première conduite de gaz (3) entre le premier système de dosage (6) et le réservoir intermédiaire (4).

14. Utilisation d'un dispositif d'alimentation en gaz selon la revendication 12 ou 13, **caractérisée en ce que** le gaz porteur est introduit par un troisième système de dosage (9).

15. Utilisation d'un dispositif d'alimentation en gaz selon la revendication 14, **caractérisée en ce que** le troisième système de dosage (9) est un limiteur de débit massique.

16. Utilisation d'un dispositif d'alimentation en gaz selon l'une quelconque des revendications 14 ou 15, **caractérisée en ce que** la pression constante p2 est réglée par les flux massiques du premier et du troisième système de dosage (6, 9), la section de l'ouverture du deuxième système de dosage (15) étant fixée.

17. Utilisation d'un dispositif d'alimentation en gaz selon l'une quelconque des revendications 12 à 16, **caractérisée en ce que** le flux massique du gaz porteur est proportionnel au flux massique du premier précurseur depuis le réservoir (2) jusqu'au réservoir intermédiaire (4).

18. Utilisation d'un dispositif d'alimentation en gaz selon l'une quelconque des revendications 1 à 17, **caractérisée en ce que** le précurseur est un composé de Nb, de Ta, de Ti ou d'Al.

19. Utilisation d'un dispositif d'alimentation en gaz selon la revendication 18, **caractérisée en ce que** le composé de Nb est NbCl₅ ou de l'éthoxyde de Nb.

20. Utilisation d'un dispositif d'alimentation en gaz selon la revendication 18, **caractérisée en ce que** le composé de Ta est TaCl₅ ou de l'éthoxyde de Ta.

21. Utilisation d'un dispositif d'alimentation en gaz selon la revendication 18, **caractérisée en ce que** le composé d'Al est AlCl₃.

22. Utilisation d'un dispositif d'alimentation en gaz selon la revendication 18, **caractérisée en ce que** le composé de Ti est de l'isopropylate de titane.

23. Utilisation d'un dispositif d'alimentation en gaz selon l'une quelconque des revendications 12 à 22, **caractérisée en ce que** le gaz porteur est un gaz inerte, un deuxième précurseur ou un mélange gazeux avec un deuxième précurseur, chacun des gaz porteurs étant sous forme gazeuse dans les conditions normales.

24. Utilisation d'un dispositif d'alimentation en gaz selon la revendication 23, **caractérisée en ce que** le gaz, porteur est ou contient de l'oxygène.
